# EUROPEAN PATENT APPLICATION

(11) **EP 1 074 355 A2**
(43) Date of publication of application: **07.02.2001**
(21) Application number: 00305924.3
(22) Date of filing: 12.07.2000
(51) Int. Cl.: B26F 1/00

(54) **Multiaxis punching device**

(30) Priority: 07.03.2000 JP 2000062644; 19.07.1999 JP 20501299
(71) Applicant: UHT Corporation, Aichi-gun, Aichi-ken (JP)
(72) Inventor: Kakimoto, Masakazu, c/o UHT Corporation, Togo-cho, Aichi-gun, Aichi-ken (JP); Tsuchida, Takashi, c/o Kanazawa R & D Center, Kanazawa-shi, Ishikawa-ken (JP); Furuya, Makoto, c/o UHT Corporation, Togo-cho, Aichi-gun, Aichi-ken (JP); Yamada, Kimoko, c/o UHT Corporation, Togo-cho, Aichi-gun, Aichi-ken (JP)
(74) Representative: Denmark, James

(57) **Abstract**

To provide a multiaxis punching device which can punch holes with a highly precise positional relationship between reference holes and product holes. In a multiaxis punching device which punches holes in a workpiece W control driven in the horizontal direction by a punch mold 15 supporting plural punches P which move back and forth under the drive of a striking source 4, reference holes a1' are provided by using a die mold 25 in an area adjoining the punch mold, and a reference hole punching unit 9 is provided in a part which is fixed relative to the back and forth motion of the punch mold 15, thereby maintaining positional precision between the product hole punches P and a reference hole punch P'.

## Description

### BACKGROUND OF THE INVENTION

### 1. Field of the Invention

This invention relates to a multiaxis punching device which punches plural holes in a thin workpiece.

### 2. Description of the Related Art

A multiaxis punching device of this type is known in the prior art which comprises a punch mold supporting plural punches which move back and forth under the drive of a striking source, and a punch plate (functioning as a stripper) or a die mold fixed relative to the back and forth motion of this punch mold, and which punches plural product holes in a workpiece which is held in a workpiece displacement mechanism and control driven in the horizontal direction.

The hole punching method employed by this multiaxis punching device may be gang die hole punching or grid pattern hole punching.

In the former, plural punches are disposed in the punch mold in alignment with a product hole pattern provided in one hole-punching area, so that all the product holes in the hole-punching area are punched when the punch mold moves back and forth once.

In the latter case, in a workpiece containing plural hole-punching areas, plural punches are disposed in the punch mold in alignment with an array of these plural hole-punching areas. By making the pitch of the hole-punching areas and the pitch of the punches the same, a product hole is punched at one position in each hole-punching area of the plural hole-punching areas for one back and forth motion of the punch mold, and by repeating the back and forth motion of the punch mold and the controlled motion of the workpiece, holes can be punched simultaneously in plural workpieces.

In addition to the punching of product holes by the above hole punching methods, a reference hole having a larger diameter than the product hole is punched in the workpiece. This reference hole is used for alignment during machining or assembly when other machining steps are performed on the workpiece or when the workpiece is delivered. The reference hole is punched at plural (usually about two) locations inside the hole-punching area or outside the hole-punching area by a hole punching unit provided at a position outside the mold, the position and number of such holes depending on the product.

However, in this multiaxis hole punching device of the prior art, as the hole punching unit which punches the reference hole is provided at a position outside the mold, and due to installation errors of this hole punching unit, or to lengthening of the distance through which the control driven workpiece is displaced in order to punch the reference hole, it was difficult to maintain good precision in the positional relationship of the reference hole and the product holes.

To resolve this problem, in the gang die hole punching method, there is also a punching device wherein the plural punches in the punch mold which move back and forth under the drive of the striking source comprise a reference hole punch. However, as the reference hole is of larger diameter than the product hole as described above, sufficient space must be reserved in the punch mold to punch this large diameter reference hole. Currently, this limitation is placing restrictions on the arrangement of the product hole punches, and to design restrictions in determining the product hole pattern.

In the grid pattern hole punching method, as the number of back and forth motions of the punch mold corresponds to the number of product holes in one hole-punching area, it is impossible to punch reference holes of larger diameter and smaller number than the product holes using a reference hole punch provided in the same punch mold, as described above, so currently, they have to be punched by a hole punching unit provided at a position outside the mold as described above.

In the punching industry which is now evolving towards manipulation of thin plate objects, a multiaxis hole punching device is strongly desired wherein the workpiece would be demarcated into plural hole-punching areas, and punch holes (product holes) of different shape would be punched simultaneously in each region or position while moving the workpiece, e.g., round punch holes (product holes) would be punched in regions or positions in plural hole-punching areas at a still narrower pitch than the punch interval in the gang die method, square punch holes (product holes) would be punched in other regions or positions, and elliptical punch holes (product holes) would be punched in yet other regions or positions.

In addition, the rim of the workpiece is made to overlap with the inner circumferential part of a frame shaped workpiece holder and held there by adhesive tape, or it is held by vacuum in the workpiece holder, and the workpiece holder is then control driven in the horizontal direction by the workpiece displacement mechanism. However, the thickness of the workpiece holder is generally 400 micrometers, and many workpieces are much thinner than this (of the order of 60 micrometers). It therefore often happens that when the workpiece holder is gripped by the workpiece displacement mechanism and displaced over a workpiece transport interval between the punch mold and the die mold, the workpiece sags due to its flexibility, and a gap is created between the upper surface of the workpiece holder and the upper surface of the workpiece.

### SUMMARY OF THE INVENTION

It is therefore an object of this invention, which was conceived to overcome the above problems, to provide a multiaxis punching device which can punch holes with a highly precise positional relationship between reference holes and product holes.

It is a further object of this invention to provide a multiaxis punching device which simultaneously punches punch holes (product holes) of different shape as required, e.g. round holes, triangular holes and rectangular holes, in desired regions of plural hole-punching areas in a workpiece held in a workpiece holder.

It is yet a further object of this invention to provide a multiaxis hole punching device which can strike punches of different shape with a single, common striking source.

The essential feature of the technical means conceived to achieve the above objects in a multiaxis punching device which punches holes in a workpiece control driven in the horizontal direction by a punch mold supporting plural punches that move back and forth under the drive of a striking source, is to provide a reference hole by using a die mold in an area adjoining the punch mold, and to provide a reference hole punching unit in a part which is fixed relative to the back and forth motion of the punch mold.

Herein, the part which is fixed relative to the back and forth motion of the punch mold may also comprise a punch plate fixed to the machine frame, or a die mold or the like fixed to a machine platform.

According to the aforesaid technical means, reference holes are provided using a die mold part in an area adjoining the punch mold, so positional precision between the reference hole punching unit which is aligned with the reference holes and the product hole punch is naturally maintained. Further, in the reference hole punching unit, the reference hole punch moves back and forth independently of the back and forth motion of the punch mold.

It is effective if the punch mold comprises plural punch sub-molds disposed in parallel in proximity to each other, punches of identical shape are supported at equidistant intervals on each of these punch sub-molds so that the punch sub-molds can move independently, punch plates are divided corresponding to the punch sub-molds, and a height position relative to the die mold of each punch plate can be adjusted.

This equidistant interval is the pitch of the hole-punching areas in the workpiece.

According to the above technique, punches of different shape are supported at equidistant intervals in each of flat, narrow rectangular punch sub-molds disposed in parallel in proximity to each other. By control driving the workpiece holder in the horizontal direction (X axis direction or Y axis direction) when a desired punch sub-mold is struck by the striking source, plural punch holes (product holes) of identical shape can be punched in the workpiece at the same position of each of the hole-punching areas which are demarcated at the pitch of the punches in each punch sub-mold.

When round punches, rectangular punches and elliptical punches are supported at equidistant intervals in each punch sub-mold, round holes, rectangular holes and elliptical holes can be punched in each hole-punching area at the pitch of the punches in the sub-mold by independently striking each punch sub-mold as the workpiece is control driven in the horizontal direction.

When a desired hole-punching area is moved into a position beneath a punch sub-mold, the punch plate at the lower end of the punch sub-mold is moved away from the die mold by height adjustment so as not to interfere with the displacement of the workpiece holder, and when the desired hole-punching area is positioned underneath the punch sub-mold which is to punch a hole, the punch plate is made to approach the workpiece and the hole is punched.

It is still more desirable if the punch mold comprises plural flat, narrow rectangular punch sub-molds disposed in parallel in proximity to each other, these plural punch sub-molds comprise plural groups of punch sub-molds wherein punches of identical shape are supported at equidistant intervals according to shape, punch plates are divided corresponding to the punch sub-molds, a height position relative to the die mold of each punch plate can be adjusted, and groups of the punch sub-molds can be struck in groups via a striking source which can be engaged or disengaged and which is control driven in the horizontal direction.

Herein, insofar as concerns the groups of plural punch sub-molds which support punches of identical shape at equidistant intervals, when for example the punch sub-molds are divided into six rows in the Y axis direction, the first group is row 1, row 3 and row 5, and the second group is row 2, row 4 and row 6, punches of different shape being supported at equidistant intervals in corresponding groups of punch sub-molds. Likewise, when they are divided into nine rows for example, the first group is row 1, row 4 and row 7, the second group is row 2, row 5 and row 8, and the third group is row 3, row 6 and row 9, punches of different shape being supported at equidistant intervals in corresponding groups of punch sub-molds. According to this invention, these numbers of groups are not exhaustive.

According to the aforesaid technical means, when for example the punch sub-molds are divided into six rows in the Y axis direction, punches of identical shape are supported at equidistant intervals in the punch sub-molds corresponding to row 1, row 3 and row 5 (hereafter referred to as group 1), punches of an identical shape different from that of group 1 are supported at equidistant intervals in the punch sub-molds corresponding to, for example, row 2, row 4 and row 6 (hereafter referred to as group 2), holes are punched by for example a round punch supported in the punch sub-molds of group 1 at desired positions in plural hole-punching areas by engaging group 1 with the striking source so as to strike group 1 as the workpiece is control driven in a horizontal direction (X axis direction or Y axis direction), and for example rectangular punch holes (product holes) are punched by a rectangular punch supported in the punch sub-molds of group 2 at desired positions in hole-punching areas by control driving the striking source, which was disengaged from the first group of punch sub-molds, in the horizontal direction and engaging it with group 2 so as to strike group 2 as the workpiece is control driven in the horizontal direction.

It is effective if the means which can be engaged or disengaged is vacuum adhesion or an electromagnet.

According to the above technical means, engaging and disengaging of the punch holding punch molds to and from the striking source can be performed by applying air suction, stopping the suction, or switching power ON and OFF.

### BRIEF DESCRIPTION OF THE DRAWINGS

Fig. 1 is a partial cutaway view schematically showing a front view of a first embodiment.
Fig. 2 shows a partial cutaway view of an enlarged cross-section of essential parts.
Fig. 3 shows an enlargement of a transverse cross-section of part of a punch sub-mold.
Fig. 4 is a partial enlarged cross-section showing a state where a punch plate (more specifically, a punch sub-mold together with a punch plate) in an outermost row in the Y axis direction is separated from a die mold to avoid interference with a workpiece holder, and only a punch sub-mold in a second row is made to approach the workpiece to punch a hole.
Fig. 5 is a plan view of a workpiece showing a typical hole punching pattern punched in the first embodiment.
Fig. 6 is a partial enlarged cross-section of essential parts according to a second embodiment, showing a state where a punch plate (more specifically, a punch sub-mold together with a punch plate) in an outermost row in the Y axis direction is separated from a die mold to avoid interference with a workpiece holder, and the punch sub-molds in a second row, fourth row and sixth row in the Y axis direction are made to approach the workpiece.
Fig. 7 is a plan view of a workpiece showing a typical hole punching pattern punched in the second embodiment.
Fig. 8 shows a partial cutaway in a plan view of a third embodiment, showing essential parts omitting a striking source, supporting plate and machine frame.
Fig. 9 is a section through (IX)-(IX) in Fig. 8.
Fig. 10 is a plan view showing a typical workpiece.

### DESCRIPTION OF THE PREFERRED EMBODIMENTS

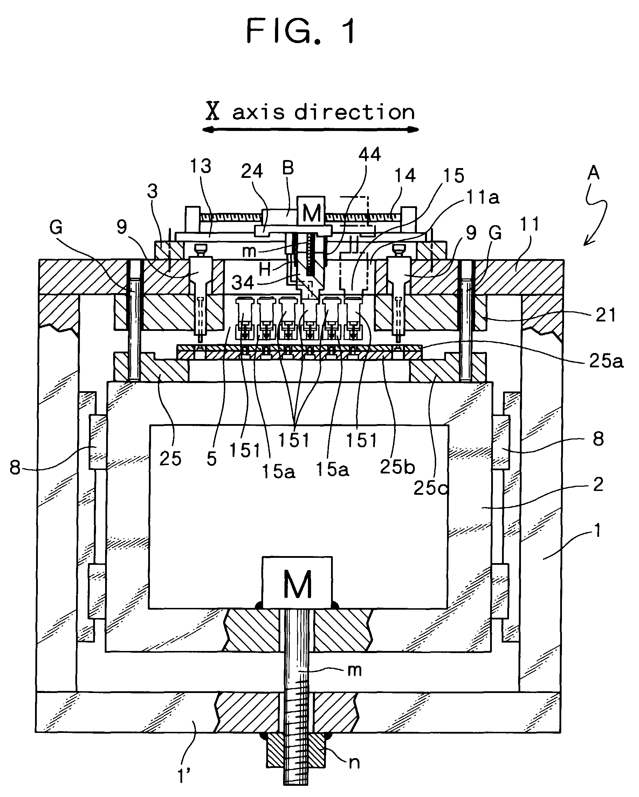

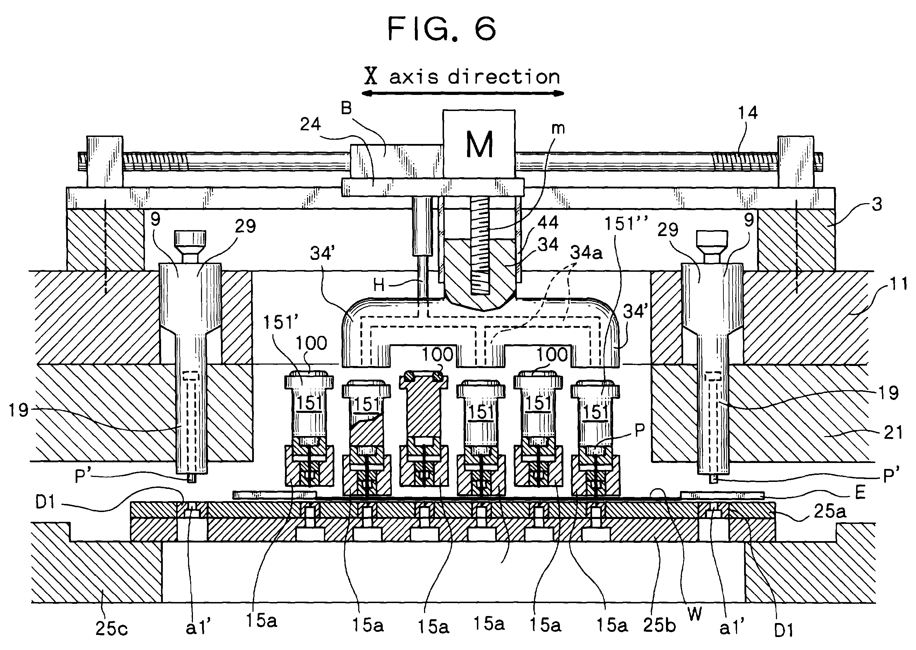

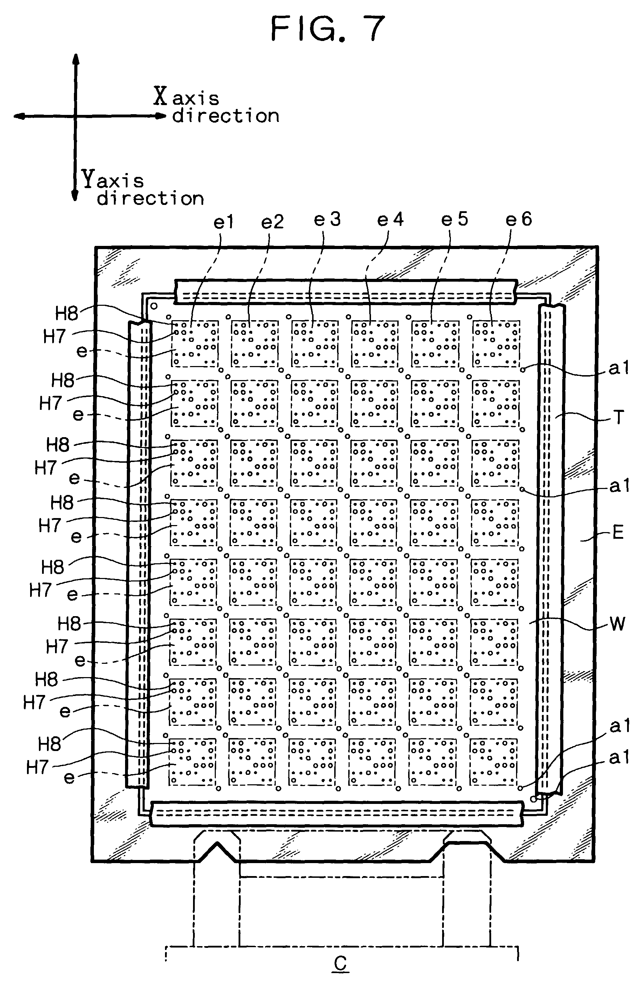

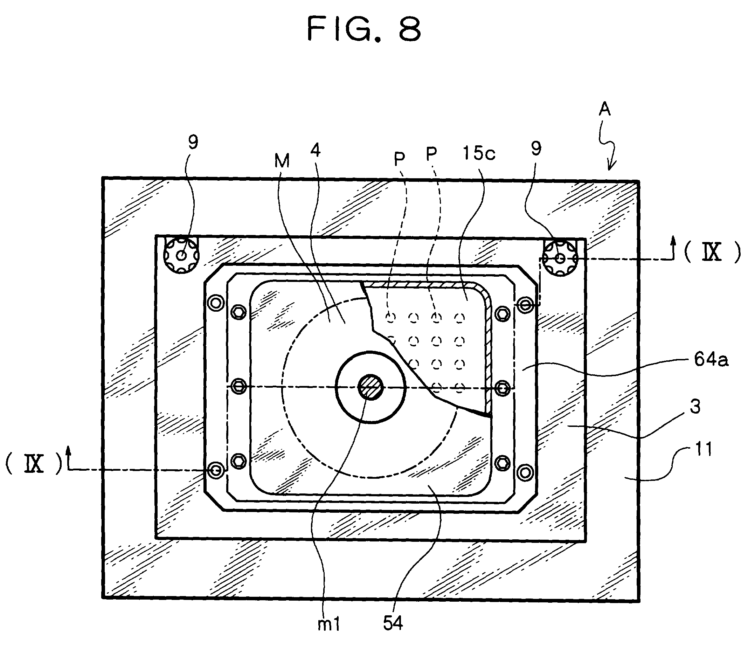

Next, some embodiments of this invention will be described referring to the drawings. Figs. 1-5 show a first embodiment of a multiaxis hole punching device according to this invention, Figs. 6 and 7 show a second embodiment, and Figs. 8 -10 show a third embodiment, respectively. Firstly, the first embodiment will be described.

This multiaxis punching device A comprises a front frame-shaped ram 1 comprising a ram plate 11 having an opening 11a in its central part as a top frame, a unit supporting platform 2 fixed on a machine platform, not shown, so that the movement of the ram 1 is controlled in a vertical direction, a fixing platform 3 fixed to the upper surface of the ram plate 11 and having an opening 13, a striking source 4 supported via a means 14 which can be control driven in the horizontal direction (the X direction in this embodiment) on this fixing platform 3, and a multiaxis hole punching mold 5, as shown in Fig. 1.

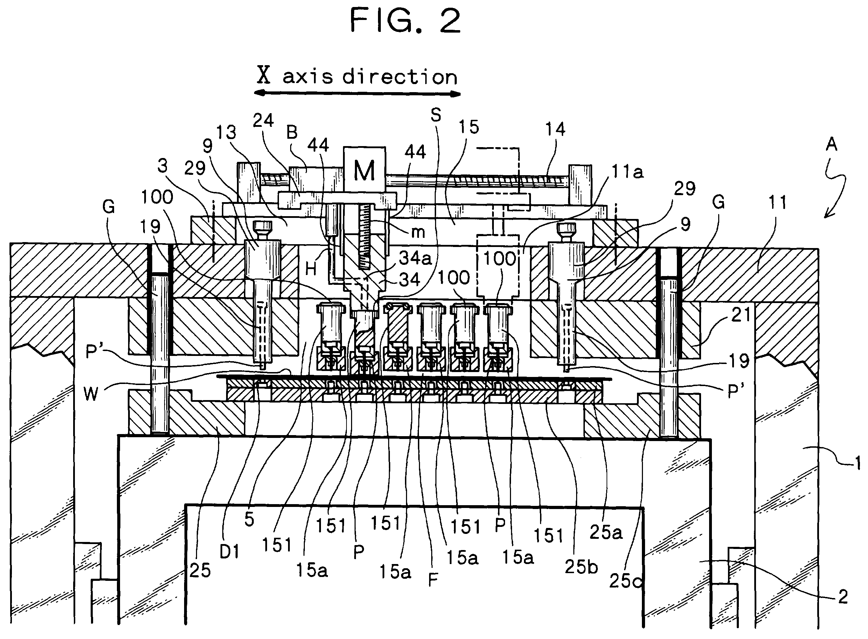

The striking source 4 can drive a supporting platform 24 on which a servomotor M is installed in the X axis direction by the means 14 which can be control driven in the X-axis direction, well known in the art, comprising a ball screw spanning the opening 13 in the fixing platform 3. A screw thread m of this servomotor M screws into a punch ram 34, and the punch ram 34 is guided so that it cannot rotate but is free to move up and down by a pair of guides 44, 44 vertically suspended from the supporting platform 24, as shown in Fig. 1 and Fig. 2.

The multiaxis hole punching mold 5 comprises a punch mold 15 comprising plural punch sub-molds 151 having a flat, narrow rectangular shape disposed in parallel and in proximity to each other, and a die mold 25 fixed at a lower level of the punch mold 15.

The punch sub-molds 151 allow the height position of a punch plate 15a to be adjusted relative to the die mold 25.

In this embodiment, the punch sub-molds 151 are divided into six rows in the Y axis direction.

The punch sub-molds 151 comprise flat, narrow rectangular punch holders 15b having punch engaging holes 15b-1 at equidistant intervals, and a backing plate 15c which is bolted so as to cover the punch engaging holes 15b-1, as shown in Figs. 2-4. Heads P1 of product hole punches P are gripped and supported at equidistant intervals between the bases of the punch engaging holes 15b-1 and the backing plate 15c, and a punch plate 15a divided in the same direction is disposed underneath this punch holder 15b.

The product hole punches P supported in this punch sub-mold 151 are punches of different diameters, e.g., elliptical punches or rectangular punches having a different transverse cross-section.

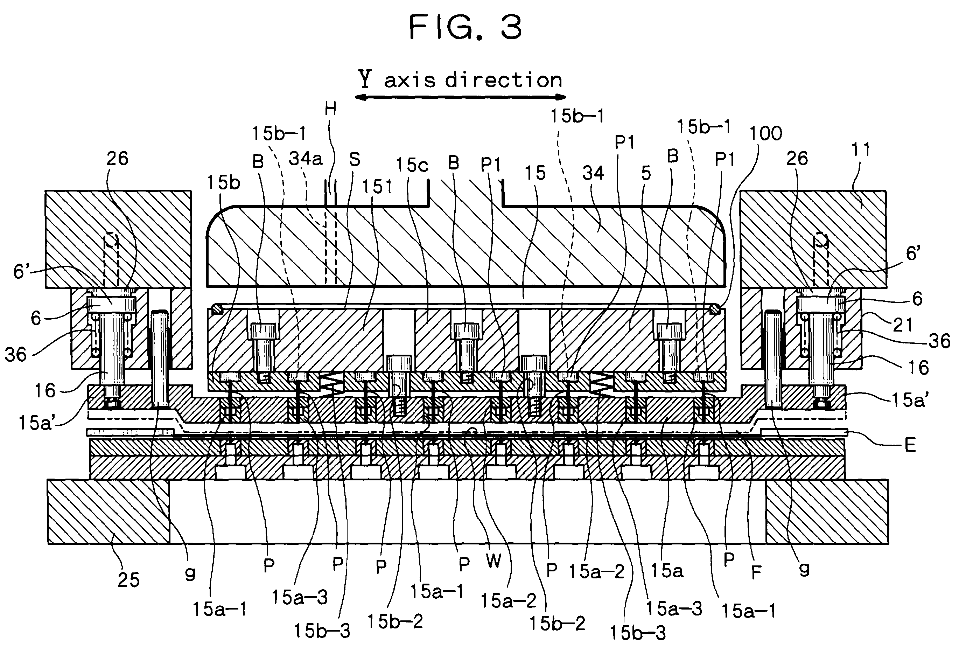

The punch plate 15a is divided in the same way as the divided punch sub-molds 151, and it has an end part extending upwards like an arm in the Y axis direction outside the region corresponding to the punch holders 15b, as shown in Fig. 3. The ends of an extending part 15a' are supported by a piston rod 16 of an air cylinder 6 provided to a frame-shaped plate 21 fixed to the rear surface of the ram plate 11. An inner part of the extending part 15a' is connected to the frame-shaped plate 21 by a guide pin g such that is free to move in a straight line. Punch insertion holes 15a-1 are provided corresponding to the punch engaging holes 15b-1, and guide bushes 15a-2 are provided on the upper side of the punch insertion holes 15a-1 or stripper bushes 15a-3 are provided on the lower side.

The air cylinder 6 is of a single acting type. When air is sent into an air chamber 26 under pressure, the piston rod 16 descends against the elastic force of a compression spring 36 underneath a piston 6', and the punch plate 15a approaches the die mold 25. Conversely, during periods of non-operation when air is not delivered, the punch plate 15a moves away from the die mold 25 (by approximately 5mm in this embodiment) under the elastic repelling force of the compression spring 36.

The punch holders 15b are fixed to the punch plate 15a at a predetermined interval by guide bolts B which pass through guide holes 15b-2 in the punch plate 15a, and compression springs 15b-3 which elastically repel the punch holders 15b upwards are interposed between the punch holders 15b so as to maintain this predetermined interval.

Therefore, when the air cylinder 6 is operated, the entire punch sub-mold 151 moves downwards together with the punch plate 15a, and when it is not operating, the entire punch sub-mold 151 moves upwards together with the punch plate 15a under the elastic repelling force of the compression spring 36 so that it moves away from the die mold 25 as described above.

The lower end of the punch ram 34 is formed in a flat, narrow rectangular shape identical to that of the top surface of the backing plate 15c, and by bringing its lower surface in intimate contact with an O ring 100 surrounded by the top surface of the backing plate 15c, a vacuum space S is formed between the top surface of the backing plate 15c and the lower surface.

In this vacuum space S, one end of a flexible hose H which can extend or contract connected with an air suction device B, is connected to a passage 34a in the lower part of the punch ram 34, this passage 34a opening onto the lower surface of same, and the assembly is held tight under vacuum by operating the air suction device B. This air suction device B is installed on the supporting platform 24 adjacent to the servomotor M.

The die mold 25 comprises a die holder 25a supporting product hole dies D corresponding to the product hole punches P supported in the punch mold 15 comprising the plural punch sub-molds 151 as shown in Figs. 1-3, a diepad 25b fixed to this die holder 25a, and a bolster plate 25c to which the diepad 25b is attached. The two ends in the X axis direction of this bolster plate 25c and the ram plate 11 are connected by guide posts G passing through the frame-shaped plate 21, the bolster plate 25c being fixed on the upper surface of the unit supporting platform 2 housed in the ram 1 as shown in Fig. 1.

The unit supporting platform 2 is hollow inside as shown in Fig. 1, and it guides the ram 1 by linear guides 8 provided on both sides. A nut n of the screw thread m connected to the servomotor M installed in this unit supporting platform 2 is fixed in a downplate 1' of the ram 1, and the height of the frame-shaped plate 21 provided with the ram plate 11 and air cylinder 6 can be adjusted in the direction of the die mold 25 under the drive of the servomotor M using the guides G as a guide. The height of the punch sub-mold 151 relative to the die mold 25 can be adjusted more finely using the height adjusting function of the punch sub-mold 151 relative to the die mold 25 by the descent of the piston rod 16, and the fine adjustment function of the frame-shaped plate 21.

The symbol 9 refers to the reference hole punching unit which punches reference holes in a diagonal corner of the workpiece W or in a diagonal corner of a hole-punching area.

This reference hole punching unit 9 is provided in parts corresponding to the reference holes a1' by effectively using parts of the die mold 25 in areas adjoining the punch mold 15, more specifically in parts to the left and right which are fixed relative to the back and forth motion of the punch mold 25.

This reference hole a1' is provided in a reference hole die D1, and is formed with this die D1 in intimate contact with the die holder 25a.

The reference hole punching unit 9 is also attached to the frame-shaped plate 21 as shown in Fig. 1. Its construction uses a well-known mechanism wherein the punches P' in a punch housing 19 attached to the frame-shaped plate 21, are made to move back and forth by air pressure supplied by an upper cylinder part 29.

The rim of the workpiece W is made to adhere by making part of it overlap with the inner rim of a workpiece holder E using an adhesive tape T, and one edge of the workpiece holder E is gripped by a workpiece displacement mechanism C and moved (control driven) in the X axis direction or Y axis direction, as shown in Figs. 3, 4 and 5.

In the multiaxis punching device A having the above construction, when the workpiece holder E gripped by the workpiece displacement mechanism C is displaced in the X direction or Y direction, and hole-punching areas e arranged in transverse or longitudinal rows are to be hole-punched by the punches of the punch sub-molds 151, the workpiece holder (thickness 400 micrometers) might obstruct the movement of the workpiece. Hence, all of the air cylinders 6 are left in the non-operating state, all of the punch sub-molds 151 are separated from the die mold 25 (by about 5mm), and a large workpiece transport interval F is left between the punch sub-molds 151 and die mold 25 through which the workpiece W is moved. In other words, although the workpiece W is not shown, the workpiece W is moved after reserving the large workpiece transport interval F between the punch sub-molds 151 and die mold 25 of Fig. 1.

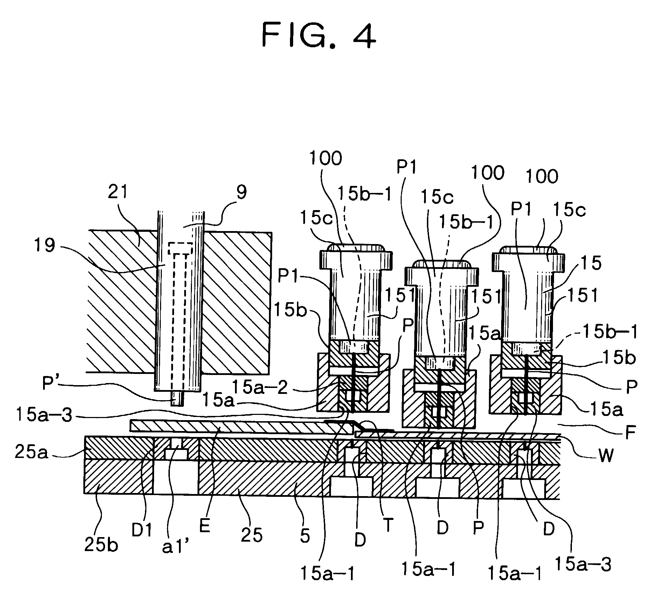

When the desired hole-punching area e in the Y axis rows (in this embodiment, there are eight hole-punching areas e in each Y axis row corresponding to the number of punches) is moved underneath a predetermined punch sub-mold 151, the air cylinder 6 connected to this punch sub-mold 151 is operated to make the punch plate 15a approach the workpiece W (Fig. 4). (In Fig. 4, the punch plate 15a in the second row from the left is moved down together with the punch sub-mold 151, and this punch plate 15a is approaching the workpiece W). In this embodiment, it approaches to 10 micrometers above the surface of the workpiece W.

The supporting platform 24 of the servomotor M is then control driven in the horizontal direction by the means 14 which can be control driven in the X axis direction, the punch ram 34 is brought exactly above the punch sub-mold 151 which is to be punched, the air in the vacuum space S is evacuated by operating the air suction device B to hold the assembly together under vacuum, the servomotor M which is the striking source is driven causing the punch ram 34 to descend, and punch holes (product holes) H1 of identical shape are punched at the same place in each hole-punching area e of the Y axis rows.

Hence, when the hole-punching areas e in the Y axis rows are moved underneath the predetermined punch sub-mold 151, in order that the punch sub-mold 151 does not obstruct the movement of the workpiece holder E and interfere with the movement of the workpiece W, the punch sub-mold 151 is first separated from the die mold 25 (by about 5 mm), the workpiece W is moved to bring the desired hole-punching area e in a Y axis row under the predetermined punch sub-mold 151, this punch sub-mold (more specifically, punch plate 15a) is made to approach the workpiece W and the hole is punched. A stripper effect can be used immediately when the punch is raised.

When the punch sub-mold 151 is placed under vacuum, the punch ram 34 is moved down after first raising it to top dead center, the under surface of the lower end of the punch ram 34 is brought into intimate contact with the O ring 100 surrounding the top surface of the backing plate, and the air suction device B is operated.

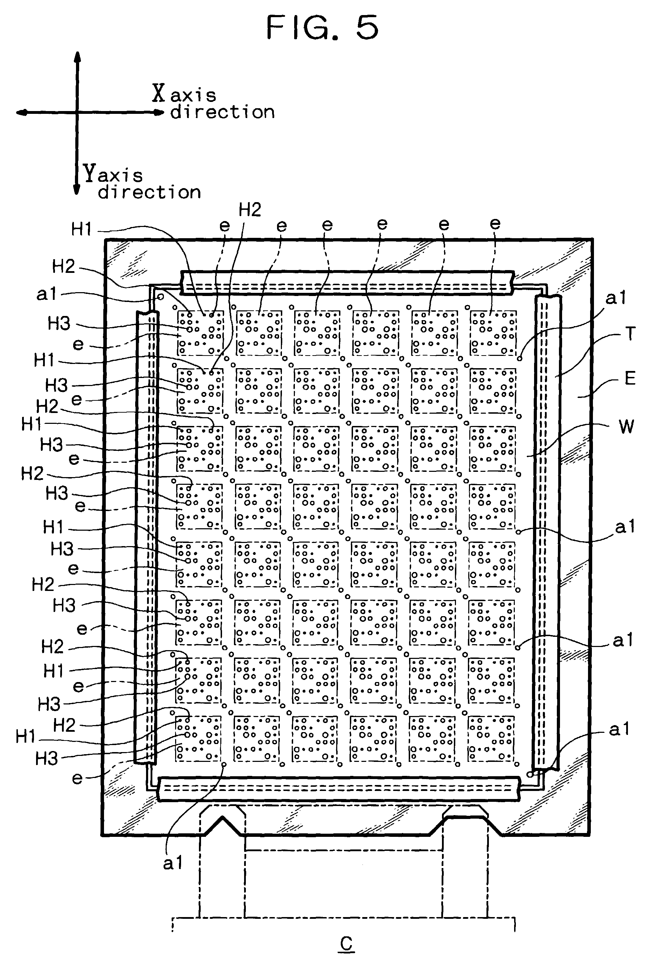

In this way, six types of punch holes (product holes) H1, H2, H3...are punched at predetermined positions in hole-punching areas e in Y axis rows as shown in Fig. 5, holes of each type being punched in one operation (in Fig. 5, punch holes (product holes) other than the punch holes (product holes) H1, H2, H3...are not shown).

When plural punch holes (product holes) H1, H2, H3 are punched as shown in Fig. 5 in the hole-punching areas e of each Y axis row, the punch sub-molds 151 are struck and controlled in synchronism with the finely controlled displacement of the workpiece displacement mechanism C in the X axis direction and Y axis direction.

The number and interval of punches supported in the punch sub-molds 151, and the number of the punch sub-molds 151, are set according to the number of sections in the hole-punching area and the shape of the holes to be punched in that area.

Reference holes a1 are punched by two reference hole punching units 9, 9 at the diagonal corners of the workpiece, and effectively in right-hand parts and left-hand parts adjacent to the diagonal corners of the hole-punching areas, as shown in Fig. 5.

Next, describing a second embodiment of this invention shown in Figs. 6 and Fig. 7, the plural punch sub-molds 151 comprise two groups of punch sub-molds 151', 151'' supporting product hole punches P of different shapes, product hole punches of identical shape being supported at equidistant intervals. These groups of product hole punch molds 151', 151'' can be struck separately by the striking source 4 which can be engaged or disengaged and which can be control driven in the horizontal direction. The construction of the punch sub-molds 151, die mold 25 and engaging/disengaging means is the same as that of the aforesaid first embodiment, and details will therefore be omitted here.

According also to this embodiment, as in the aforesaid embodiment, the punch sub-molds 151 are divided into six rows in the Y axis direction.

The punch ram 34 is divided into three parts midway along its length so that the punch sub-mold 151 comprising row 1, row 3 and row 5 in the Y axis direction from the left of Fig. 6 (hereafter referred to as the first group 151'), and the punch sub-mold 151 comprising row 2, row 4 and row 6 in the figure (hereafter referred to as the second group 151'') can be struck separately.

The punches P of identical shape (for large diameter round holes) are supported at equidistant intervals in the first group 151', and the punches P of another identical shape (for small diameter round holes) are supported at equidistant intervals in the second group 151''.

According also to this embodiment, eight hole-punching areas e are arranged in a row in the Y axis direction in the workpiece W corresponding to the number of the punches P supported in the punch sub-molds 151.

In the multiaxis punching device A having the aforesaid construction, when the workpiece W gripped by the workpiece holder E is moved in the X axis direction or Y axis direction within the workpiece transport interval F by the workpiece displacement mechanism C, considering that the workpiece holder (thickness 400 micrometers) E may obstruct the movement of the workpiece W, all of the air cylinders 6 are left in the non-operating state, and all the punch sub-molds 151 are separated (by about 5mm) from the die mold 25, which is the same as in the previous embodiment.

When for example small diameter punch holes (H8) are punched by the second group 151'' in each hole-punching area e of the hole-punching areas e1, e3, e5 which are the first row, third row and fifth row in the Y axis direction as shown in Fig. 6 and 7, as in the case when they are punched by the second group 151'' in each hole-punching area e of the hole-punching areas e2, e4, e6 which are the second row, fourth row and sixth row in the Y axis direction, the workpiece holder E is moved so that the hole-punching areas e1, e3, e5 or e2, e4, e6 are positioned underneath the second group 151'', and only the air cylinders 6 of the punch sub-molds 151 in the second group 151'' are operated to make the punch sub-molds 151 approach the workpiece W.

The supporting platform 24 of the servomotor M is then control driven in the horizontal direction by the means 14 which is control driven in the X axis direction, arms 34' of the punch ram 34 are positioned exactly over the punch sub-molds 151 forming the second group 151'', the air suction device B is operated to evacuate air from the vacuum space S and hold the assembly together under vacuum, the servomotor M is driven by the striking source to lower the punch ram 34, and the small diameter punch holes (product holes) H8 are simultaneously punched in each hole-punching area e of the hole-punching areas e1, e3, e5 or each hole-punching area e of the hole-punching areas e2, e4, e6.

On the other hand, when large diameter punch holes (product holes) H7 are to be punched by the first group 151' in the hole-punching areas e1, e3, e5 which are the first row, third row and fifth row in the Y axis direction, or in the hole-punching areas e2, e4, e6 which are the second row, fourth row and sixth row, the workpiece holder E is moved so that the hole-punching areas e1, e3, e5 or hole-punching areas e2, e4, e6 are positioned underneath the first group 151', only the air cylinders 6 of the punch sub-molds 151 of the first group 151' are operated to make the punch sub-molds 151 approach the workpiece W, the arms 34' of the punch ram 34 are positioned exactly over the punch sub-molds 151 forming the first group 151', vacuum is applied, the punch ram 34 is lowered, and the large diameter punch holes (product holes) H7 are simultaneously punched in the hole-punching areas e1, e3, e5 or hole-punching areas e2, e4, e6 in the same way as described above.

In this embodiment, only two types of punch are installed, however punch patterns with all kinds of variations are possible by disposing plural punch sub-molds in parallel, supporting plural types of punch in a regular array in the punch sub-molds, and providing a corresponding number of punch ram arms.

An electromagnet may also be used if desired as the means to engage and disengage the striking source 4 and punch sub-molds 151.

In this case, the electromagnetic may be provided at the tip of the punch ram 34 in the first embodiment and at the tips of the punch ram arms 34' in the second embodiment so as to attract or release the backing plate 15c.

Next, a third embodiment will be described referring to Figs. 8-10.

This multiaxis punching device A comprises the striking source 4 fixed via the fixing platform 3 on the upper surface of the front frame-shaped ram 1 comprising a ram plate 11 having an opening 11a in its central part as a top frame, the punch mold 15 which is moved back and forth vertically by the striking source 4, the punch plate 15a fixed relative to the back and forth motion of the punch mold 15, the die mold 25, and the reference hole punching unit 9 installed together with this punch plate 15a, and simultaneously punches plural holes in the workplace W which is control driven in the horizontal direction.

The striking source 4 comprises a screw m1 at the tip of the output shaft of the servomotor M, and is fixed to the fixing platform 3. The output shaft m1 of the servomotor M passes with a clearance through a center opening 3a formed in the middle of the fixing platform 3.

A shuttle member 54 formed in an approximate flange shape screws onto a thread 54a formed in the center of the screw m1, this shuttle member 54 performing a back and forth motion in a vertical direction when the servomotor M is forward driven or reversed.

An effectively inverted depression-shaped bracket 64 having a flange 64a is fixed to the lower surface of the shuttle member 54 by a fixing means permitting attachment and detachment such as adhesion or screwing, the punch mold 15 screwing onto the lower surface of this bracket 64 by the flange 64a.

Plural punch engaging holes 15b-1 having a stepped shape so as to engage the heads P1 of the product hole punches P, are opened in the punch mold 15, the product hole punches P are threaded vertically in the punch engaging holes 15b-1, and the heads P1 of the product hole punches P are thereby gripped between the punch engaging holes 15b-1 and the backing plate 15c.

When the multiaxis punching device of this embodiment is used for gang die hole punching, the product hole punches P are disposed in alignment with a product hole pattern in one hole-punching area, and when it is used for grid pattern hole punching, they are disposed in alignment with an array of the plural hole-punching areas e.

A suitable number of guide bushes 17 having guide pins 7 passing through them are fixed to the outer circumference of the punch mold 15.

The guide pins 7 are fixed to the punch plate 15a, described later. A suitable number of depressions opening downwards are formed further towards the inside than the guide bushes 17 on the lower surface of the punch mold 15, and return assist springs 200 are gripped between these depressions and depressions formed facing the backing plate 15c.

Therefore, the punch mold 15 is driven in a vertical direction by the striking source 4 with assistance due to the repelling force of the return assist springs 200, and the direct stability of this up/down motion is maintained by the guide pins 7 and guide bushes 17.

The die mold 25 comprises the die holder 25a which supports the die D corresponding to the product hole punches P, the diepad 25b fixed to this die holder 25a and the bolster plate 25c to which the diepad 25b is fixed, and it is fixed on the unit supporting platform 2 leaving the interval F through which the workpiece W can be transported underneath the punch plate 15a.

The punch plate 15a has a rectangular shape parallel to the punch mold 15, and it has plural guide holes 15d formed corresponding to the product hole punches P. Guide bushes which guide the back and forth motion of the product hole punches P fit in these guide holes 15d.

This punch plate 15a is fixed to the underside of the ram plate 11 of the ram 1 via a supporting frame 15e fixed to the outer circumferential upper surface, leaving sufficient space for transport of the workpiece W underneath and leaving sufficient space for the punch plate mold 15 to move back and forth vertically on the upper surface side.

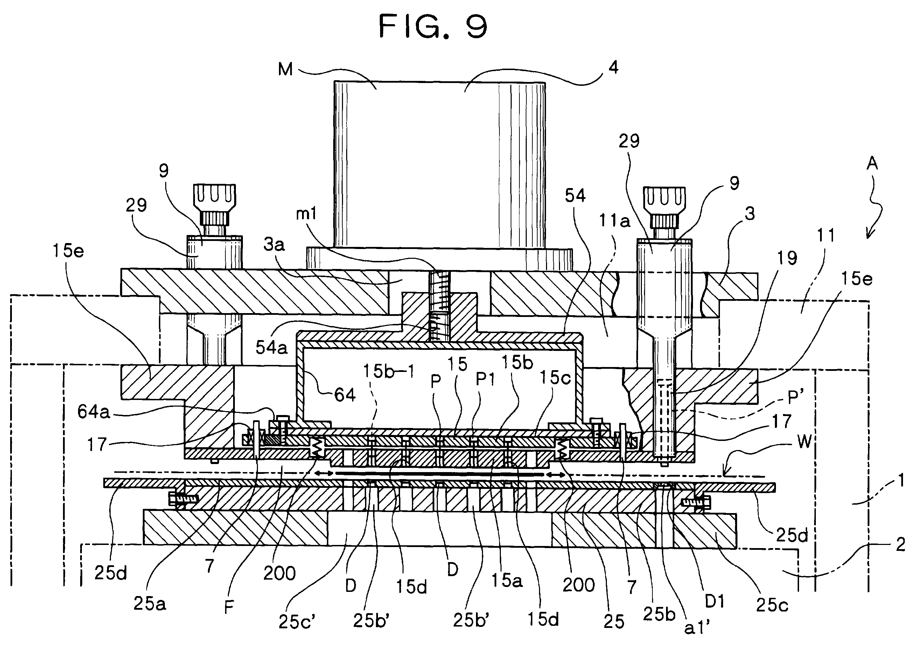

The supporting frame 15e is a frame-shaped member whereof the side parts have a transverse cross-sectional inverted L-shape, the reference hole punching units 9 being provided respectively at the rear to the left and right, as shown in Fig. 9.

Transverse cross-sectional inverted L-shaped supporting plates 25d are screw-fixed on the left and right sides of this die mold 25 so that their upper surfaces effectively form one surface with the upper surface of the die holder 25a, as shown in Fig. 9, this supporting plate 25d supporting, from beneath, the outer rim of the workpiece W which is control driven towards the reference hole punching unit 9, described later when the reference holes a1 are punched in the workpiece W.

Plural discharge holes 25b' are bored in the diepad 25b corresponding to the product hole dies D so that punching gas released from the workpiece during hole punching, can be discharged.

The bolster plate 25c is fixed to the upper surface of the unit supporting platform 2, a rectangular opening 25c' is formed enclosing plural discharge holes 25b' in the center part of the diepad 25b, and punching gas discharged from the discharge holes 25b' of the diepad 25b via this opening 25c' is aspirated by a vacuum device, not shown.

The reference hole punching units 9 are mechanisms, well-known in the art, identical to that of the aforesaid embodiment wherein the reference hole punches P' in the lower punch housing 19 are moved back and forth vertically under air pressure supplied by the upper cylinder part 29, and are fixed by brackets at the rear to the left and right of the supporting frame 15e (Fig. 8). The reference holes a1 are punched in the workpiece W between the reference hole punches P' and the reference hole die D1 fitted to the die holder 25a.

Discharge holes, extending from the lower surface of this reference hole die D1 to the lower surface of the bolster plate 25c via the diepad 25b, are formed on the lower surface of the reference hole die D1. The punching gas discharged when the reference holes a1 are punched is aspirated from these discharge holes by the aforesaid vacuum device.

In the punch housing 19 of this reference hole punching unit 9, a punch support hole is formed from the supporting frame 15e to the punch plate 15a, and a guide bush, not shown, which guides this reference hole punch P' or punch P' is provided therein. As a result of this construction, the reference hole punch P' moves up and down in the punch support hole due to the air pressure supplied by the cylinder 29, and on each occasion, its tip moves in and out of the punch plate 15a and punch hole a1' in the die D1 to punch the reference hole a1.

In the example shown in the figure, the reference hole punching unit 9 was provided in two positions at the rear of the supporting frame, but this arrangement and number are not exhaustive.

The means which moves the reference hole punch P' back and forth was air drive, but an identical drive system to that used for the striking source can also be employed.

The mechanism which control drives the workpiece W in the horizontal direction is a ball screw mechanism, or a well-known XY displacement mechanism having a moving platform, not shown. The workpiece W is placed underneath the workpiece displacement mechanism C, and the workpiece W is transported between the punch plate 15a and die holder 25a.

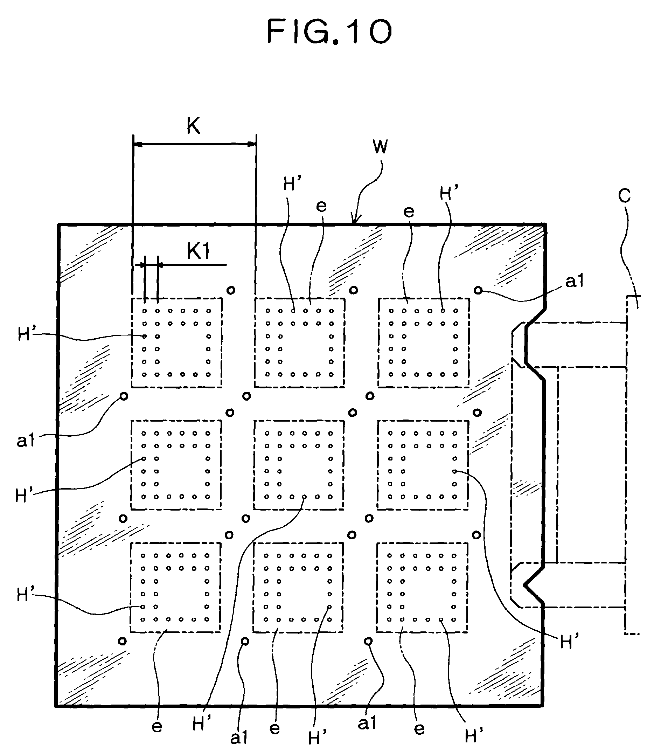

Thus, according to the multiaxis punching device A having the above construction, the workpiece W is gripped by the workpiece displacement mechanism C, and this workpiece displacement mechanism C is control driven in the horizontal direction. The workpiece W is thereby transported between the punch plate 15a and die holder 25a to correspond with the plural reference hole punches P (Fig. 9). When this multiaxis punching device is adapted to the gang die hole punching method, the horizontal displacement distance of the workpiece W is set to a pitch K between the plural hole-punching areas e, and all product holes H' are punched by alternating between back and forth motion of the punch mold 15 and horizontal motion of the workpiece W (Fig. 10).

In other words, punching of one of the hole-punching areas e is performed by one back and forth motion of the punch mold 15, and after displacing the workpiece W horizontally by the pitch K, punching is performed in the next hole-punching area e. The punching of all the hole-punching areas e is completed by repeating these operations. The reference hole a1 is punched by the reference hole punching unit 9 which is driven independently of the punch mold 15 before or after the product holes H' in the hole-punching areas are punched. The reference hole punching units 9 are installed in a one-piece construction with the punch plate 15a, so the reference holes a1 and product holes H' are punched with a highly precise positional relationship.

When this multiaxis punching device is adapted to the grid pattern hole punching method, the horizontal displacement distance of the workpiece W is set to a pitch K1 between the plural product holes H' in one hole-punching area e, and all the product holes H' are punched by alternating between the back and forth motion of the punch mold 15 and the horizontal motion of the workpiece W with the pitch K1 (Fig. 10).

In other words, punching of a hole at one position of all the hole-punching areas e is performed by one back and forth motion of the punch mold 15, and after displacing the workpiece W horizontally by the pitch K1, the next punching operation by the punch mold 15 is performed. The punching of all the hole-punching areas e is completed by repeating these operations.

The reference hole a1 is punched by the reference hole punching unit 9 which is driven independently of the punch mold 15, the workpiece W being control driven to correspond with the reference hole punching unit 9 (Fig. 9) before or after all the product holes H' are punched.

### Effects of the Invention

According to this invention, as described above, reference holes are provided using a die mold part in an area adjoining a punch mold, a reference hole punching unit is provided in a part which is fixed relative to the back and forth motion of the punch mold, and positional precision is maintained between a reference hole punching unit naturally aligned with the reference holes, and a product hole punch. Therefore, the reference holes and product holes are punched with a highly precise positional relationship.

In addition, the reference hole punch moves back and forth independently of the punch mold which moves back and forth, and punches reference holes in a workpiece which is control driven in the horizontal direction. Hence, the product hole pattern is not limited by the reference hole punch as in the prior art where the reference hole punch is provided in the punch mold, and the degree of design freedom in determining the arrangement of product holes and reference holes is thereby increased.

By providing punch sub-molds which can be moved independently while the workpiece is control driven in the horizontal direction (X axis direction or Y axis direction), punch holes (product holes) of corresponding shapes to the punches supported in the punch sub-molds can be punched in hole-punching areas in the workpiece at the pitch of the punches in the punch sub-molds.

Further, by moving the punch sub-molds in synchronism with the control of the workpiece in the horizontal direction, punch holes (product holes) of identical shape can be punched at high density in the hole-punching areas in the workpiece.

When holes are punched, the height of each punch plate relative to the die mold can be adjusted. Therefore, when a desired hole-punching area is moved underneath a desired punch sub-mold, the punch plate of the punch sub-mold is moved to a high position where it does not interfere with the movement of a workpiece holder, and ample space is reserved for transport of the workpiece. The workpiece is then moved, and only the punch plate of the desired punch sub-mold is made to approach the workpiece to punch the hole. As a result, a large gap is not left between the punch sub-mold and workpiece as would for example occur if the holes were punched leaving a large space for the workpiece to move between the punch plates of all the punch sub-molds and the die mold, causing the workpiece to "dance" (rising up of the workpiece due to sticking to the punch used for punching, or falling out of the workpiece due to the stripper function of the punch plate), and having an adverse effect on hole precision due to the impact of same.

After a punch sub-mold which interferes with the workpiece holder is separated therefrom, another punch sub-mold can be made to approach the workpiece within a range surrounding the workpiece holder, so in addition to preventing "dancing" of the workpiece, a wide workpiece range surrounded by the workpiece holder can be effectively used as a hole-punching area region.

If desired punches of different shapes such as round punches, rectangular punches and elliptical punches are supported in each punch sub-mold, by striking the selected punch sub-mold as the workpiece is control driven in the horizontal direction, round punch holes (product holes), rectangular punch holes (product holes) and elliptical punch holes (product holes) can be punched separately in desired regions of the hole-punching areas which are demarcated at the punch pitch. Even if there are round punches of different diameter, punch holes (product holes) for each diameter can be punched in desired regions of the hole-punching areas demarcated at the punch pitch, and all kinds of punching pattern variations may be selected.

As the punch sub-molds having a flat, narrow rectangular shape are formed from a punch mold split into plural parts in one plane, the surface area is not increased, and the space occupied by the device is the same as that of a prior art multiaxis punching unit.

Moreover, by providing groups of plural punch sub-molds holding punches of different shapes, wherein punches of identical shape are arranged at equidistant intervals, and striking each group via a striking source which can be engaged or disengaged and control driven in the horizontal direction, a group of punch sub-molds which supports punches of identical shape at equidistant intervals can be selectively struck by one striking source. As a result, punch holes (product holes) of different shapes can be punched simultaneously in desired regions of hole-punching areas corresponding to this group of punch sub-molds demarcated at the punch pitch, equipment costs are lowered, and hole punching efficiency is largely increased.

Further, the means used to engage and disengage the striking source and the punch sub-molds is vacuum suction which can be turned on or off, or an electromagnet, so engaging and disengaging of the striking source and the punch sub-molds is simple to perform.

Having described specific preferred embodiments of the invention with reference to the accompanying drawings, it will be appreciated that the present invention is not limited to those precise embodiments, and that various changes and modifications can be effected therein by one of ordinary skill in the art without departing from the scope of the invention as defined by the appended claims.

## Claims

1. A multiaxis punching device which produces holes by a punch mold supporting plural punches, which move back and forth under the drive of a striking source, in a workpiece which is control driven in the horizontal direction, wherein a reference hole is provided using a die mold in an area adjoining said punch mold which moves back and forth, and a reference hole punching unit is provided in a part which is fixed relative to the back and forth motion of the punch mold.

2. A multiaxis punching device as defined in Claim 1, wherein said punch mold comprises plural flat, narrow rectangular punch sub-molds disposed in parallel in proximity to each other, punches of identical shape are supported at equidistant intervals on each of these punch sub-molds so that said punch sub-molds can move independently, punch plates are divided corresponding to said punch sub-molds, and a height position relative to the die mold of each punch plate can be adjusted.

3. A multiaxis punching device as defined in Claim 1, wherein said punch mold comprises plural flat, narrow rectangular punch sub-molds disposed in parallel in proximity to each other, punches of identical shape are supported at equidistant intervals on each of these punch sub-molds so that the punch sub-molds can move independently, punch plates are divided corresponding to the punch sub-molds, a height position relative to the die mold of each punch plate can be adjusted, and groups of said punch sub-molds can be struck in groups via a striking source which can be engaged or disengaged and which is control driven in the horizontal direction.

4. A multiaxis punching device as defined in Claim 3, wherein said means which can be engaged or disengaged is vacuum adhesion or an electromagnet.
